# EUROPEAN PATENT APPLICATION

(11) **EP 2 234 167 A2**
(43) Date of publication of application: **29.09.2010**
(21) Application number: 10250598.9
(22) Date of filing: 26.03.2010
(51) Int. Cl.: H01L 31/0224, H01L 31/05

(54) **Solar cell and solar cell module**

(30) Priority: 27.03.2009 JP 2009080605
(71) Applicant: Sanyo Electric Co., Ltd., Osaka 570-8677 (JP)
(72) Inventor: Tsujimoto, Hironobu, Moriguchi, 5-5, City Osaka 570-8677 (JP); Santanda, Yayoi, Moriguchi, 5-5, City Osaka 570-8677 (JP)
(74) Representative: Calderbank, Thomas Roger

(57) **Abstract**

In the solar cell 10 according to the embodiment, the rear surface of the solar cell substrate 20 has the electrode formation region Ra, which is a rectangular region formed by connecting line segments along the outer edge of the plurality of rear-surface-side thin wire electrodes 30B. The electrode formation region Ra includes the first region R1 and the second region R2 which has a greater exposed area of the solar cell substrate 20 per unit area than that of the first region R1. The second region R2 is formed at the edge portion of the rear surface in the perpendicular direction T.

## Description

This application is based upon and claims the benefit of priority from prior Japanese Patent Application No. 2009-080605, filed on March 27, 2009; the entire contents of which are incorporated herein by reference.

The present invention relates to a solar cell and a solar cell module including a rear-surface-side current-collecting electrode.

The solar cell is expected as a new energy source because the solar cell directly converts clean, inexhaustibly supplied sunlight into electricity. Such solar cell has an output on the order of several watts per cell. Thus, when a solar cell is used as an electric power source (energy source) for a house or a building, a solar cell module including plurality of solar cells arranged in a matrix form is used.

Specifically, the solar cell module includes a plurality of solar cell strings each having a predetermined number of solar cells arranged along an arrangement direction. The plurality of solar cell strings are arranged approximately parallel to each other in the perpendicular direction to the arrangement direction. In each of the plurality of solar cell strings, the predetermined number of solar cells are electrically connected to each other by a wiring member.

In this process, a technique is known, in which the plurality of solar cell strings are temporarily connected to each other by temporarily fixing adjacent solar cells to each other with an adhesive tape (refer to Japanese Patent Application Publication No. 2003-324211). According to this technique, in a manufacturing process of a solar cell module, contact of the plurality of solar cell strings to each other due to displacement thereof can be prevented.

With the technique of Patent Literature 1, the adhesive tape is bonded to current-collecting electrodes formed on an approximately entire surface of each solar cell. However, since each current-collecting electrode is formed with e.g. conductive paste, the adhesive strength between the current-collecting electrode and the adhesive tape is low. Consequently, use of the adhesive tape has a problem in that the adhesive tape may come off the solar cell and the displacement of the solar cell string tends to occur.

The invention is made in view of the above-mentioned problem, and it is an object of the invention to provide a solar cell and a solar cell module capable of preventing displacement of the solar cell string.

An aspect of the present invention is summarized as a solar cell to which a wiring member is connected along a predetermined direction, the solar cell comprising: a solar cell substrate having a principal surface; and an electrode formed on an approximately entire surface of the principal surface, wherein the principal surface has an electrode formation region which is a rectangular region formed by connecting line segments along an outer edge of the electrode, the electrode formation region includes a first region and a second region having a larger exposed area of the solar cell substrate per unit area than in the first region, and the second region is formed at an edge portion of the principal surface in a direction approximately perpendicular to the arrangement direction.

Another aspect of the present invention is summarized as a solar cell module comprising a plurality of solar cells sealed between a light-receiving-surface side protection member and a rear-face side protection member, wherein the plurality of solar cells are arranged in an arrangement direction, and are connected to each other by a wiring member, each of the plurality of solar cells includes: a solar cell substrate having a principal surface; and an electrode formed on an approximately entire surface of the principal surface, and in at least one solar cell of the plurality of solar cells, the principal surface has an electrode formation region which is a rectangular region formed by connecting line segments along an outer edge of the electrode, the electrode formation region includes a first region and a second region having a larger exposed area of the solar cell substrate per unit area than in the first region, and the second region is formed at an edge portion of the principal surface in a direction approximately perpendicular to the arrangement direction.

In the above aspect of the present invention, the electrode may include a plurality of thin wire electrodes, and each of the plurality of thin wire electrodes may be formed to extend in a direction approximately perpendicular to the arrangement direction.

In the above aspect of the present invention, the plurality of thin wire electrodes may be not formed in the second region.

In the above aspect of the present invention, the number of the plurality of thin wire electrodes per unit area may be smaller in the second region than in the first region.

Another aspect of the present invention is summarized as a solar cell comprising; a photovoltaic body, a plurality of thin wire electrodes on a surface of the photovoltaic body, wherein the plurality of thin wire electrodes include at least an thin wire electrode which has smaller length than other thin electrodes.

### In the drawings:

Fig. 1 is a side view of a solar cell module 100 according to an embodiment of the invention.

Fig. 2 is a plan view illustrating the configuration of a solar cell module 100 according to the embodiment of the invention.

Fig. 3 is a plan view from light-receiving-surface-side of a solar cell 10 according to the embodiment of the invention.

Fig. 4 is a plan view from the rear-surface-side of the solar cell 10 according to the embodiment of the invention.

Fig. 5 is a plan view illustrating a manufacturing method of the solar cell module 100 according to the embodiment of the invention.

Fig. 6 is an enlarged plan view illustrating a manufacturing method of the solar cell module 100 according to the embodiment of the invention.

Fig. 7 is an exploded cross-sectional view illustrating a manufacturing method of the solar cell module 100 according to the embodiment of the invention.

Fig. 8 is an enlarged plan view illustrating an arrangement position of a temporary fixing tape according to the embodiment of the invention.

Next, the embodiments of the invention are described with reference to the drawings. In the following description of the drawings, identical or similar reference numerals are assigned to identical or similar components. However, the drawings are schematic, thus it should be noted that the dimensions are not shown to scale. Accordingly, specific dimensions should be recognized in consideration of the following description. Also, there are inevitably included some portions of the drawings between which a dimensional relationship and/or a scale are inconsistent.

### [Configuration of Solar Cell Module]

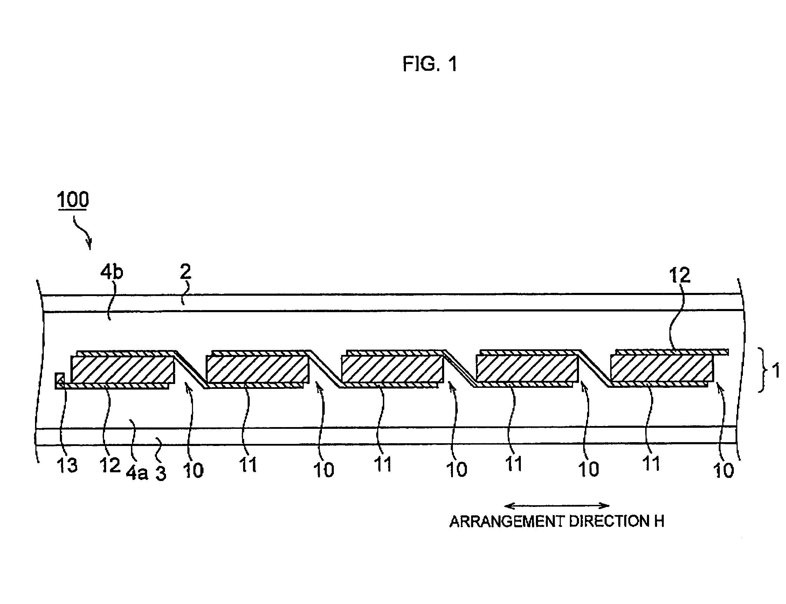

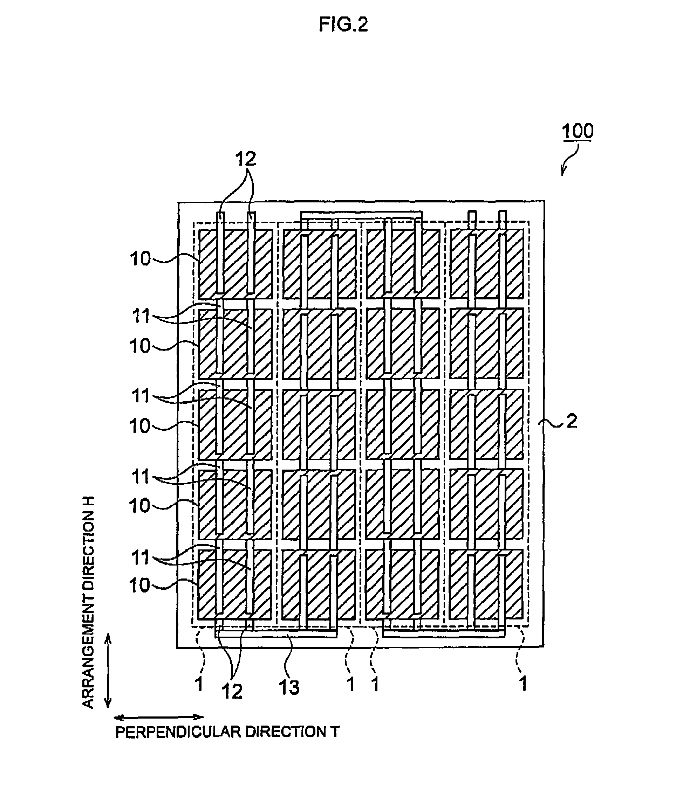

In the following, the schematic configuration of a solar cell module according to the embodiment of the invention is described with reference to the drawings. Fig. 1 is a side view of the solar cell module 100 according to the embodiment of the invention. Fig. 2 is a plan view of the solar cell module 100 according to the embodiment of the invention.

As shown in Figs. 1 and 2, the solar cell module 100 includes a plurality of solar cell strings 1, a light-receiving-surface-side protection member 2, a rear-surface-side protection member 3, a first sealing member 4a, and a second sealing member 4b.

Each of the plurality of solar cell strings 1 includes a plurality of solar cells 10 arranged in an arrangement direction H, a first wiring member 11, a second wiring member 12, and a third wiring member 13. The plurality of solar cell strings 1 are arranged approximately parallel to each other in a perpendicular direction T which is approximately perpendicular to the arrangement direction H.

The plurality of solar cells 10 are sealed between the light-receiving-surface-side protection member 2 and the rear-surface-side protection member 3. The plurality of solar cells 10 are arranged along the arrangement direction H. Each of the plurality of solar cells 10 has a solar cell substrate and electrodes formed on the solar cell substrate. Each of the plurality of solar cells 10 has a light receiving surface and a rear surface provided on the opposite side to the light receiving surface. Each of the light receiving surface and the rear surface is a principal surface of the solar cell substrate. The configuration of each solar cell 10 is described below.

The first wiring member 11 electrically connects the plurality of solar cells 10 to each other. Specifically, one end of the first wiring member 11 is connected to the electrode formed on the light receiving surface of one solar cell 10, and the other end of the first wiring member 11 is connected to the electrode formed on the rear surface of another solar cell 10 adjacent to the one solar cell 10.

The second wiring member 12 is connected to each of a pair of the solar cells 10 located at both ends of each solar cell string 1. The second wiring member 12 extends to the outside of each solar cell string 1.

The third wiring member 13 electrically connects the plurality of solar cell strings 1 to each other. Specifically, one end of the third wiring member 13 is connected to the second wiring member 12 of one solar cell string 1, and the other end of the third wiring member 13 is connected to the second wiring member 12 of another solar cell string 1 adjacent to the one solar cell string 1.

Each of the first wiring member 11, the second wiring member 12, and the third wiring member 13 can be formed of a conductive material such as Cu molded in a thin plate shape or a twisted wire shape. The surface of the conductive material may be covered with Pb-free solder (for example, SnAg3.oCuo.5 solder).

The light-receiving-surface-side protection member 2 is disposed on the light-receiving-surface-side of the plurality of solar cells 10, and protects the surface of the solar cell module 100. As the light-receiving-surface-side protection member 2, glass having a translucency and an imperviousness to water or translucent plastic may be used.

The rear-surface-side protection member 3 is disposed on the rear-surface-side of the plurality of solar cells 10, and protects the rear surface of the solar cell module 100. As the rear-surface-side protection member 3, a resin film such as PET (Polyethylene Terephthalate) or a laminated film having a structure in which an Al foil is sandwiched between resin films may be used.

The first sealing member 4a and the second sealing member 4b seal the plurality of solar cell strings 1 between the light-receiving-surface-side protection member 2 and the rear-surface-side protection member 3. As the first sealing member 4a and the second sealing member 4b, a translucent resin such as EVA, EEA, PVB, silicon, urethane, acrylic, and epoxy may be used. The first sealing member 4a and the second sealing member 4b may be composed of a same material or a different material to each other.

Although not shown, a terminal box is provided on the rear-surface-side protection member 3, and in the terminal box the second wiring member 12 connected to the pair of solar cells 10 located at both ends of each of the plurality of solar cell strings 1. An Al frame or the like may be mounted to the circumference of the solar cell module.

### [Configuration of Solar Cell]

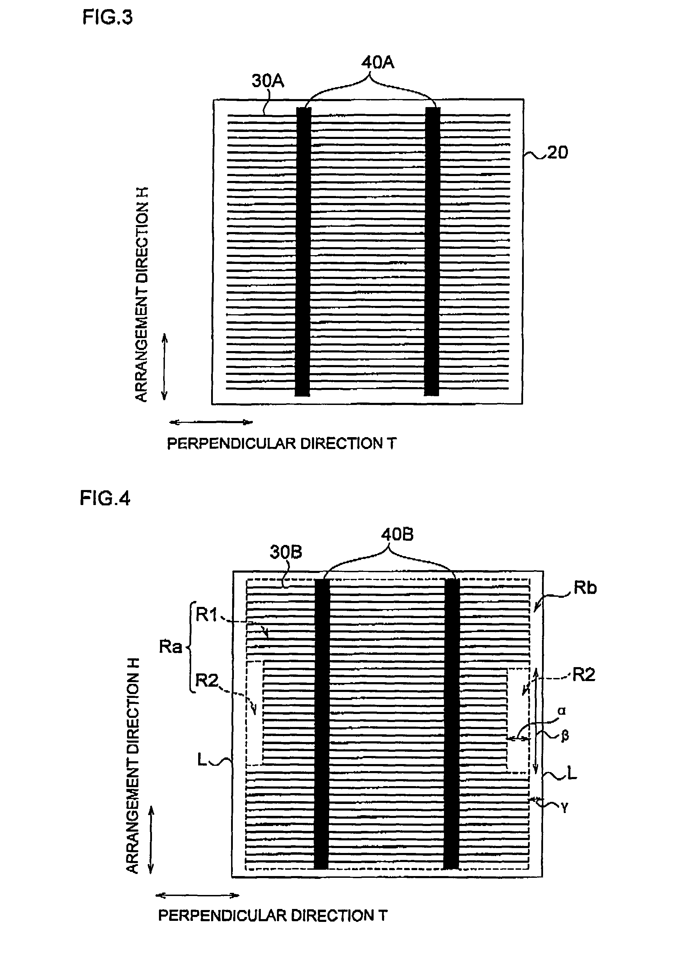

In the following, the configuration of a solar cell according to the embodiment of the invention is described with the reference to the drawings. Fig. 3 is a plan view from the light-receiving-surface-side of the solar cell 10 according to the embodiment. Fig. 4 is a plan view from the rear-surface-side of the solar cell 10 according to the embodiment.

As shown in Figs. 3 and 4, the solar cell 10 includes a solar cell substrate 20, a plurality of light-receiving-surface-side thin wire electrodes 30A, two light-receiving-surface-side connecting electrodes 40A, a plurality of rear-surface-side thin wire electrodes 30B, and two rear-surface-side connecting electrodes 40B.

The solar cell substrate 20 has a light receiving surface to receive light and a rear surface provided on the opposite side to the light receiving surface. Each of the light receiving surface and the rear surface is a principal surface of the solar cell substrate 20. The solar cell substrate 20 generates a carrier (a pair of electron and hole) by receiving light. The solar cell substrate 20 has, for example, a p-type region and an n-type region internally, and a semiconductor bonding is formed at the interface between the p-type region and the n-type region. The solar cell substrate 20 can be formed of a well-known semiconductor material for a solar cell such as a crystalline silicon semiconductor, e.g., a single crystalline silicon or a polycrystalline silicon, or a compound, e.g., a GaAs semiconductor. However, the invention is not limited to these cases, and may have various configurations conventionally well-known.

It should be noted that the solar cell substrate 20 according to the embodiment can generate a photo-generated carrier by receiving light on each of the light receiving surface and the rear surface. The light receiving surface and the rear surface of the solar cell substrate 20 are formed with a TCO (transparent conducting oxide) film, a semiconductor layer, or a semiconductor substrate.

The plurality of light-receiving-surface-side thin wire electrodes 30A are formed on approximately entire light receiving surface of the solar cell substrate 20, and collect carriers from the solar cell substrate 20. As shown in Fig. 3, the plurality of light-receiving-surface-side thin wire electrodes 30A are formed along a perpendicular direction T on the light receiving surface of the solar cell substrate 20.

The two light-receiving-surface-side connecting electrodes 40A are the electrodes for connecting the first wiring members 11. Each of the two light-receiving-surface-side connecting electrodes 40A is formed along the arrangement direction H on the light receiving surface of the solar cell substrate 20, and intersects the plurality of light-receiving-surface-side thin wire electrodes 30A. Each of the two light-receiving-surface-side electrodes 40A for connection collects carriers that have been collected from the solar cell substrate 20 by the plurality of light-receiving-surface-side thin wire electrodes 30A.

The plurality of rear-surface-side thin wire electrodes 30B are formed on an approximately entire rear surface of the solar cell substrate 20. The plurality of rear-surface-side thin wire electrodes 30B are the electrodes that collect carriers from the solar cell substrate 20. As shown in Fig. 4, the plurality of rear-surface-side thin wire electrodes 30B are formed along the perpendicular direction T on the rear surface of the solar cell substrate 20. The plurality of rear-surface-side thin wire electrodes 30B include at least an rear-surface-side thin wire electrodes 30B which has smaller length than other rear-surface-side thin wire electrodes 30B.

The two rear-surface-side connecting electrodes 40B are the electrodes that connect the first wiring members 11. Each of the two rear-surface-side connecting electrodes 40B is formed along the arrangement direction H on the rear surface of the solar cell substrate 20, and intersects the plurality of rear-surface-side thin wire electrodes 30B. Each of the two rear-surface-side electrodes 40B collects carriers that have been collected from the solar cell substrate 20 by the plurality of rear-surface-side thin wire electrodes 30B.

Each of the electrodes above-mentioned may be formed using resin type conductive paste containing a resin material as a binder and conductive particles such as silver particles. Ceramic type conductive paste may be used in substitution for the resin type conductive paste. The number and dimensions of each electrode are appropriately determined in consideration of the dimensions and physical properties of the solar cell substrate 20.

In the embodiment, the rear surface of the solar cell substrate 20 has an electrode formation region Ra and a circumferential region Rb as shown in Fig. 4. The electrode formation region Ra is a rectangular region formed by connecting line segments along the outer edge of the plurality of rear-surface-side thin wire electrodes 30B. The circumferential region Rb is a region that surrounds the circumference of the electrode formation region Ra. On the circumferential region Rb, the plurality of rear-surface-side thin wire electrodes 30B are not formed.

The electrode formation region Ra includes a first region R1 and second regions R2.

The first region R1 is a region where the plurality of rear-surface-side thin wire electrodes 30B are formed. Thus, the first region R1 covers the most of the rear surface of the solar cell substrate 20. In a plan view of the rear surface of the solar cell substrate 20, the solar cell substrate 20 is exposed between the plurality of rear-surface-side thin wire electrodes 30B on the first region R1. Therefore, in the embodiment, the exposed area of the solar cell substrate 20 per unit area is smaller than the unit area on the first region.

Each of the second regions R2 is a region where the exposed area of the solar cell substrate 20 per unit area is greater than that of the first region R1. In the embodiment, some of the plurality of rear-surface-side thin wire electrodes 30B are formed to be shorter in length than the rest of the plurality of rear-surface-side thin wire electrodes 30B, and the plurality of rear-surface-side thin wire electrodes 30B are not formed in the second regions R2. Thus, in a plan view of the rear surface of the solar cell substrate 20, the solar cell substrate 20 is exposed in the entire second regions R2. Therefore, in the embodiment, the exposed area of the solar cell substrate 20 per unit area on the second region is approximately equal to the unit area.

The second regions R2 are formed at edge portions of the electrode formation region Ra in the perpendicular direction T. Specifically, the second regions R2 are each formed along a side L of the sides that outlines the rear surface of the solar cell substrate 20, the side L extending in the arrangement direction H. The second regions R2 are formed along the arrangement direction H. For example, when the dimension of the solar cell substrate 20 is approximately 100 mm × 100 mm, the width α of the second region R2 is approximately 1.5 mm, and the length β of the second region R2 is approximately 30 mm; however the invention is not limited to these dimensions. The width α and length β of the second region R2, i.e., the dimensions of the planar shape of the second region R2 are appropriately determined in consideration of the carrier collection efficiency of the plurality of rear-surface-side thin wire electrodes 30B.

In the embodiment, the pair of the second regions R2 is formed along the pair of respective sides extending to the arrangement direction H; however, the invention is not limited to this configuration. For example, one second region R2 may be formed on the rear surface of the solar cell substrate 20. In the embodiment, the first region R1 is formed on both sides of the arrangement direction of the second regions R2 in; however, the invention is not limited to this configuration. For example, the first region R1 may be formed only on one side of the arrangement direction H of the second region R2.

The circumferential region Rb surrounds the circumference of the electrode formation region Ra. For example, when the dimension of the solar cell substrate 20 is approximately 100 mm × 100 mm, the width γ of the circumferential region Rb is approximately 1.5 mm, but the circumferential region Rb may not be provided.

### [Manufacturing Method of Solar Cell Module]

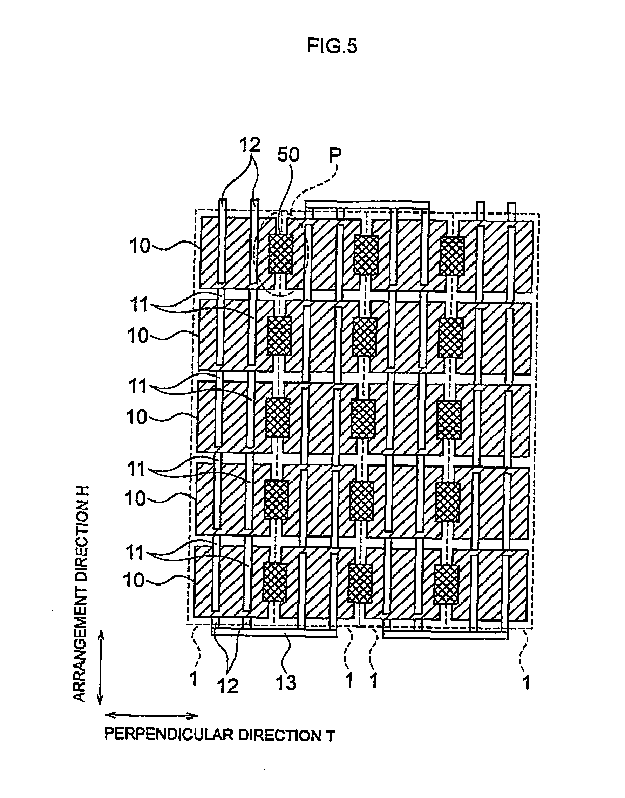

In the following, a manufacturing method of the solar cell module 100 according to the embodiment of the invention is described with the reference to the drawings. Figs. 5 to 7 are plan views and a cross-sectional view illustrating a manufacturing method of the solar cell module 100.

First, various electrodes are formed with a predetermined pattern by printing a conductive paste on the solar cell substrate 20 (see Fig. 3).

The plurality of solar cells 10 are arranged along the arrangement direction H, and are electrically connected to each other by the first wiring member 11. Subsequently, the second wiring member 12 is connected to a pair of the solar cells 10 located at both ends of the plurality of solar cells 10. Thereby, the plurality of solar cell strings 1 are produced.

Next, the plurality of solar cell strings 1 are arranged parallel to each other. In this arrangement, the plurality of solar cells 10 are arranged with their rear surfaces upside.

Next, as shown in Fig. 5, adjacent solar cells 10 in the perpendicular direction T are temporarily fixed to each other by a temporary tape 50. Accordingly, respective distances between adjacent solar cell strings 1 are fixed to a predetermined distance (for example, approximately 2 mm).

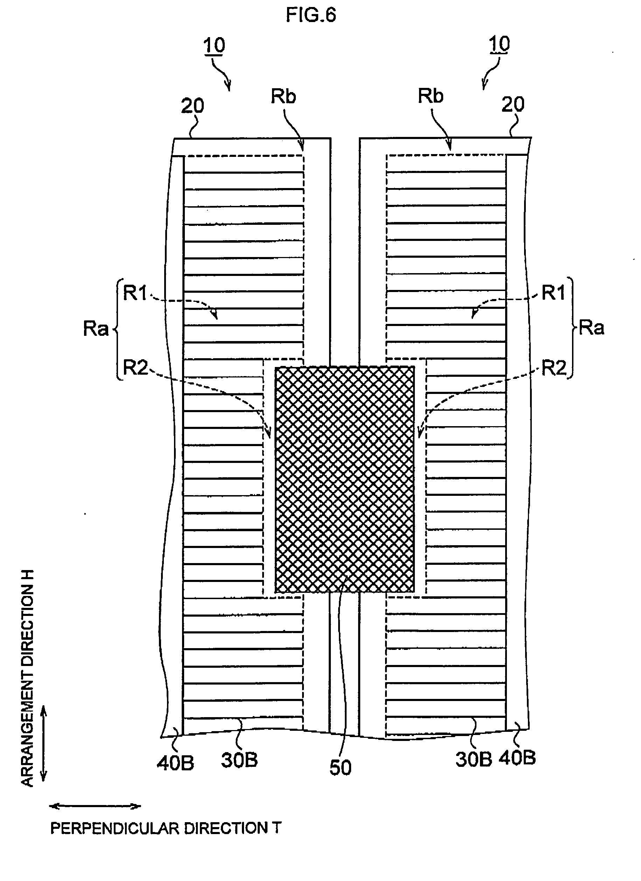

Fig. 6 is an enlarged view of a portion P of Fig. 5. As shown in Fig. 6, the temporary fixing tape 50 is applied across the rear surface of one solar cell 10 and the rear surface of the other solar cell 10 adjacent to the one solar cell 10 in the perpendicular direction T. Specifically, the temporary fixing tape 50 is applied to a second region R2 of the rear surface of the solar cell substrate 20. Since no electrode is formed in the second region R2 in the embodiment, the temporary fixing tape 50 is applied to the solar cell substrate 20.

Next, as shown in Fig. 5, respective second wiring members 12 of adjacent solar cell strings 1 are connected to each other by the third wiring member 13.

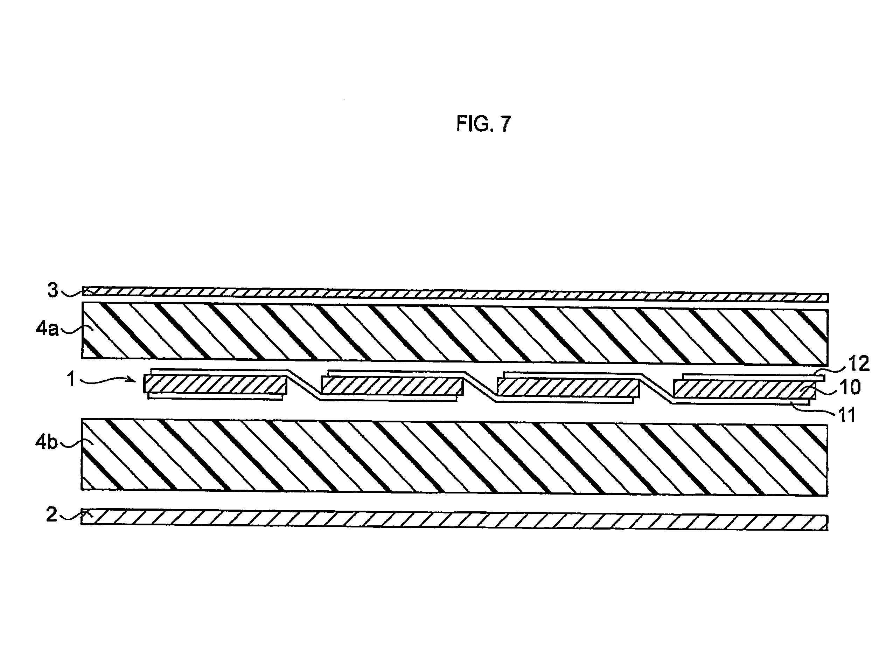

Next, as shown in Fig. 7, a laminated body is formed by sequentially laminating the light-receiving-surface-side protection member 2, the second sealing member 4b, the plurality of solar cell strings 1, the first sealing member 4a, and the rear-surface-side protection member 3.

Next, the first sealing member 4a and the second sealing member 4b are cured by heating the laminated body for a predetermined time period.

### [Operation and Effect]

In the solar cell 10 according to the embodiment, the rear surface of the solar cell substrate 20 has the electrode formation region Ra, which is a rectangular region formed by connecting line segments along the outer edge of the plurality of rear-surface-side thin wire electrodes 30B. The electrode formation region Ra includes the first region R1 and the second region R2 which has a greater exposed area of the solar cell substrate 20 per unit area than that of the first region R1. The second region R2 is formed at the edge portion of the rear surface in the perpendicular direction T.

Thus, the temporary fixing tape 50 can be applied to the second region R2 which has a greater exposed area of the solar cell substrate 20. In general, the adhesive strength of the temporary fixing tape 50 to the solar cell substrate 20 is greater than that of the temporary fixing tape 50 to the electrodes. Thus, the adhesive strength of the temporary fixing tape 50 to the solar cell substrate 20 can be increased more than that of the temporary fixing tape 50 to the first region R1. Consequently, an occurrence of displacement of the solar cell string can be prevented.

Also, the amount of light entering from the rear-surface-side protection member 3 into the rear surface of the solar cell substrate 20 can be increased by forming the second region R2. Consequently, the conversion efficiency of the solar cell 10 can be improved.

In particular, the second region R2 is formed at an edge portion of the rear surface of the solar cell substrate 20. Thus, the formation of the second region R2 makes it easier to take in the light that enters from the light-receiving-surface side protection member 2 side, and is reflected by the rear-surface-side protection member 3.

### [Other Embodiments]

Although the invention has been described according to the embodiment and its modifications described above, it should be understood that the discussion and drawings which form part of the disclosure are not intended to limit the invention. Various alternative embodiments, implementation examples, and application techniques will be apparent to those skilled in the art.

For example, in the embodiment described above, the exposed area of the solar cell substrate 20 per unit area in the second region R2 is made greater than that in the first region R1 by forming no plurality of rear-surface-side thin wire electrodes 30B in the second region R2; however, the invention is not limited to this configuration. Specifically, the exposed area of the solar cell substrate 20 per unit area in the second region R2 can be made greater than that in the first region R1 by providing a less number of the plurality of rear-surface-side thin wire electrodes 30B in the second region R2 than in the first region R1, or by providing a narrower line width of the plurality of rear-surface-side thin wire electrodes 30B in the second region R2 than in the first region R1.

In the embodiment described above, the solar cell 10 includes the plurality of rear-surface-side thin wire electrodes 30B as current-collecting electrodes; however, the invention is not limited to this configuration. The solar cell 10 may include entire surface electrodes formed so as to cover the entire first region. Even in this case, the adhesive strength of temporary fixing tape 50 can be increased by exposing the solar cell substrate 20 in the second region. In this case, the electrode formation region Ra is a rectangular region formed by connecting line segments along the outer circumference of the entire surface electrodes.

In the embodiment described above, the second region R2 is formed on the rear surface of the solar cell substrate 20; however, the second region R2 may be formed on the light receiving surface of the solar cell substrate 20.

In the embodiment described above, the solar cell module 100 includes the plurality of solar cell strings 1; however, the solar cell module 100 may include only one solar cell string 1. Even in this case, the solar cell string 1 can be firmly fixed to the first sealing member 4a. Consequently, a displacement of the solar cell string 1 during the manufacturing process of the solar cell module 100 can be prevented.

Thus, it should be understood that the invention includes various embodiments not specifically described herein. Accordingly, the technical scope of the invention should be defined only by the specifications of the invention according to the claims based on the above description.

### [Examples]

In the following, examples of the solar cell module according to the invention are specifically described; however, the invention is not limited to the examples described below, and may be modified within the scope of not changing the spirit of the invention and implemented.

### [Example 1]

First, two pieces of solar cell substrate (125 mm squares, 200 µm thickness) which have so-called HIT structure were prepared.

Next, on respective light receiving surfaces of two pieces of the solar cell substrate, 50 pieces of thin wire electrodes (line width: 100 µm, pitch: 2 mm) were formed by printing silver paste with screen printing method.

Next, on respective rear surfaces of two pieces of the solar cell substrate, 100 pieces of thin wire electrodes (line width: 100 µm, pitch: 1 mm) were formed by printing silver paste with screen printing method. Thereby, two pieces of solar cell were formed.

In this step, on the rear surface of the solar cell substrate, there were formed the rectangular electrode formation region Ra connecting line segments along the outer edge of 100 thin wire electrodes, and the circumferential region Rb (width γ= 1.5 mm) surrounding the circumference of the electrode formation region Ra. In the electrode formation region Ra, there were formed the first region R1 in which 100 thin wire electrodes had been formed, and the second region R2 in which thin wire electrodes had not been formed. In Example 1, the second region R2 had dimensions of α = 1.5 mm in width and β= 30 mm in length.

### [Example 2]

In Example 2, the second region R2 had dimensions of α = 3.5 mm in width and β= 30 mm in length.

Other processes and dimensions of the components were the same as those of Example 1.

### [Example 3]

In Example 3, the second region R2 had dimensions of α = 4.5 mm in width and β= 30 mm in length.

Other processes and dimensions of the components were the same as those of Example 1.

### [Comparative Example]

In the comparative example, the second region R2 was not formed in the electrode formation region Ra. That is, 100 thin wire electrodes were uniformly formed in the entire electrode formation region Ra.

### Other processes and dimensions of the components were the same as those of Example 1.

### [Tensile Strength Test]

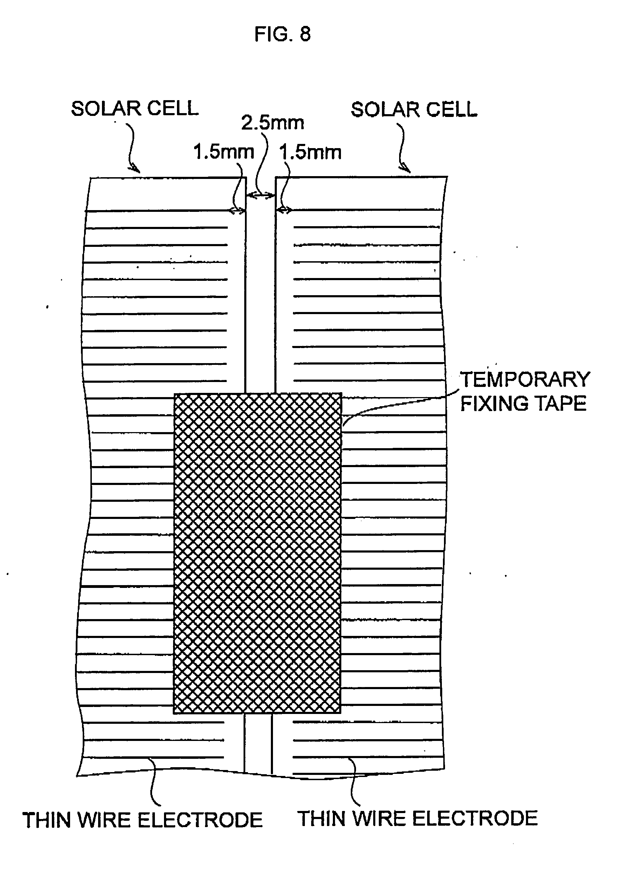

First, suppose a case where two solar cell strings are connected to each other. As shown in Fig. 8, two solar cells were arranged with a distance of 2.5 mm, and then rear surfaces thereof were connected to each other by a temporary fixing tape (15 mm in width, and 30 mm in length). In this step, the temporary fixing tape was arranged so as to cover the second region R2 of each of two solar cells in the first to third example. On the other hand, in the comparative example, the second region R2 was not formed in each of two solar cells, thus the temporary fixing tape was applied across the electrode formation regions Ra of respective two solar cells.

Next, the tensile strength [N] of the temporary fixing tape applied between the two solar cells was measured by pulling the two solar cells in a direction to be spaced away until the temporary fixing is peeled off from either one of the rear surfaces of the solar cells. The measurement results are shown in the table below. The table below lists the values of tensile strength in example 1 to 3 normalized with respect to the actual measurements of the comparative example.

**[Table 1]**

| | Tensile Strength |
|---|---|
| Example 1 | 1.13 |
| Example 2 | 1.17 |
| Example 3 | 1.20 |
| Comparative Example | 1.00 |

As shown in the above table, in examples 1 to 3, it was verified that the tensile strength was greater than that of the comparative example. This is because, in examples 1 to 3, the temporary fixing tape was applied to the second region R2 where the exposed area of the solar cell was relatively large, and thus the adhesive strength of the temporary fixing tape to the solar cell substrate was allowed to be greater. On the other hand, in the comparative example, the temporary fixing tape was applied to the electrode formation region Ra where the exposed area of the solar cell was relatively small, thus the adhesive strength of the temporary fixing tape to the solar cell substrate was smaller.

Thus, it has been verified that a displacement of the solar cell string can be prevented by bonding the temporary fixing tape 50 to the second area R2 where exposed area of the solar cell substrate 20 is relatively large.

## Claims

1. A solar cell to which a wiring member is connected along a predetermined direction,
the solar cell comprising:
a solar cell substrate having a principal surface; and
an electrode formed on an approximately entire surface of the principal surface, wherein
the principal surface has an electrode formation region which is a rectangular region formed by connecting line segments along an outer edge of the electrode,
the electrode formation region includes a first region and a second region having a larger exposed area of the solar cell substrate per unit area than in the first region, and
the second region is formed at an edge portion of the principal surface in a direction approximately perpendicular to the predetermined direction.

2. A solar cell module comprising a plurality of solar cells sealed between a light-receiving-surface side protection member and a rear-face side protection member, wherein
the plurality of solar cells are arranged in an arrangement direction, and are connected to each other by a wiring member,
each of the plurality of solar cells includes:
a solar cell substrate having a principal surface; and
an electrode formed on an approximately entire surface of the principal surface, and
in at least one solar cell of the plurality of solar cells,
the principal surface has an electrode formation region which is a rectangular region formed by connecting line segments along an outer edge of the electrode,
the electrode formation region includes a first region and a second region having a larger exposed area of the solar cell substrate per unit area than in the first region, and
the second region is formed at an edge portion of the principal surface in a direction approximately perpendicular to the arrangement direction.

3. The solar cell module according to claim 2, wherein
the electrode includes a plurality of thin wire electrodes, and
each of the plurality of thin wire electrodes is formed to extend in a direction approximately perpendicular to the arrangement direction.

4. The solar cell module according to claim 3, wherein the plurality of thin wire electrodes are not formed in the second region.

5. The solar cell module according to claim 3, wherein the number of the plurality of thin wire electrodes per unit area is smaller in the second region than in the first region.

6. A solar cell comprising;
a photovoltaic body,
a plurality of thin wire electrodes on a surface of the photovoltaic body, wherein
the plurality of thin wire electrodes include at least an thin wire electrode which has smaller length than other thin electrodes.
